# EUROPÄISCHE PATENTSCHRIFT

(11) **EP 0 498 003 B1**
(45) Veröffentlichungstag und Bekanntmachung des Hinweises auf die Patenterteilung: **11.09.1996**
(21) Anmeldenummer: 91101537.8
(22) Anmeldetag: 05.02.1991
(51) Int. Cl.: H03G 3/20, H03G 1/00

(54) **Integrierbare Schaltungsanordnung zum Detektieren eines Nutzsignales innerhalb eines verrauschten Eingangssignales**
Integrated circuit for detecting signals freed of background noise
Circuit intégré pour détecter un signal utile libéré de signaux de bruit de fond

(43) Veröffentlichungstag der Anmeldung: 12.08.1992
(73) Patentinhaber: SIEMENS AKTIENGESELLSCHAFT, 80333 München (DE)
(72) Erfinder: Bichler, Helmut, W-8032 Gräfelfing (DE)

(56) Entgegenhaltungen:
- EP-A- 0 342 671
- GB-A- 1 568 513
- US-A- 4 293 822

## Beschreibung

Die Erfindung betrifft eine integrierbare Schaltungsanordnung zum Detektieren eines digitalen Nutzsignales in einem verrauschten Eingangssignal.

In einer Vielzahl von Anwendungen ist es erforderlich, das Nutzsignal innerhalb eines verrauschten Eingangssignales zu detektieren. Dies ist beispielsweise bei der Übertragung von digitalen Daten notwendig. Werden digitale Daten beispielsweise durch Amplitudenmodulation übertragen, so wird eine digitale Null durch kein Signal und eine digitale Eins durch eine Sinusschwingung definierter Amplitude und Frequenz übertragen. Eine Detektorschaltung hat nun die Aufgabe, diese Sinusschwingung zu erkennen und ein entsprechendes Ausgangssignal zu erzeugen, welches von nachfolgenden Schaltungseinheiten in ein digitales Signal zurückgewandelt werden kann. Oftmals ist auf dem Übertragungsweg das Nutzsignal mit einem Rauschsignal überlagert. Dies ist vor allem bei Infrarotsendern und -empfängern der Fall, da in der Umgebung von derartigen Übertragungssystemen meist Störquellen wie Leuchtstoffröhren, Glühlampen und sonstige im Infrarotbereich emittierende Systeme vorhanden sind. Die Ausgangsspektren dieser für die Datenübertragung störenden Systeme können dabei schmal oder breitbandig sein.

In der europäischen Offenlegungsschrift EP-A-0 342 671 ist eine automatische Verstärkungsregelung (AGC) für einen FM-Empfänger beschrieben. Diese enthält mindestens eine AGC-Stufe, durch deren Ausgang ein FM-Detektor gesteuert wird. Das Ausgangssignal der AGC-Stufe wird außerdem einem Amplitudendetektor zugeführt, in dem das Signal mit einer Schwellenspannung verglichen wird. In Abhängigkeit von der Schwellenspannung wird die Verstärkung der AGC-Stufe nachgeregelt. Der FM-Empfänger weist dadurch verbesserte Rauscheigenschaften auf. Der ausgangsseitige FM-Detektor dient zur FM-Demodulation des empfangenen, verstärkten Signals.

Aufgabe der Erfindung ist es, eine eingangs genannte integrierbare Schaltungsanordnung anzugeben, die auch innerhalb eines stark verrauschten Eingangssignales das Nutzsignal sicher detektiert.

Diese Aufgabe wird gelöst durch eine integrierbare Schaltungsanordnung zum Detektieren eines digitalen Nutzsignales in einem verrauschten Eingangssignal mit:
- einer regelbare Verstärkungseinheit mit einem Eingang, einem Ausgang und einem Steuereingang, wobei dem Eingang das Eingangssignal zugeführt wird,
- zwei Detektoreinheiten mit je einem Eingang und einem Ausgang, wobei von jeder Detektoreinheit jeweils dann ein Ausgangssignal erzeugt wird, wenn ein ihr zugeführtes Eingangssignal eine im jeweiligen Detektor gebildete Detektorschwelle überschreitet, wobei die Detektorschwelle des ersten Detektors unterhalb der Schwelle des zweiten Detektors liegt und wobei die Eingänge der beiden Detektoren mit dem Ausgang der Verstärkungseinheit und der Ausgang des ersten Detektors mit dem Steuereingang der Verstärkungseinheit verbunden ist, so daß die Verstärkungseinheit über den ersten Detektor gegengekoppelt ist,
- einer Ausgangsklemme, die mit dem Ausgang des zweiten Detektors verbunden ist und an der das Ausgangssignal der Schaltungsanordnung abgreifbar ist.

Ausgestaltungen und Weiterbildungen des Erfindungsgedankens sind in den Unteransprüchen gekennzeichnet.

Vorteil der Erfindung ist, daß die vorgestellte Schaltungsanordnung je nach Störsignal sich selbst an die Übertragungsbedingungen anpaßt.

Die Erfindung wird nachfolgend anhand von zwei Figuren naher erläutert. Es zeigen:
- Figur 1: ein Blockschaltbild einer erfindungsgemäßen Schaltungsanordnung,
- Figur 2: ein Ausführungsbeispiel eines erfindungsgemäßen Detektors.

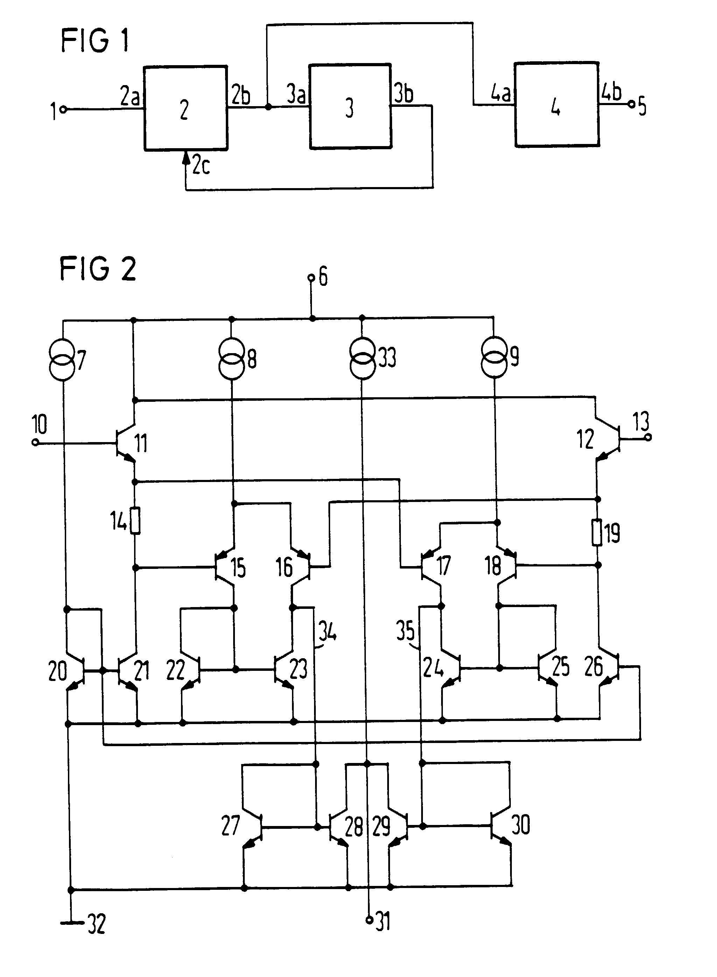

Figur 1 zeigt eine erste Eingangsklemme 1, die mit dem Eingang 2a einer Verstärkungseinheit 2 verbunden ist. Die Verstärkungseinheit 2 weist weiterhin einen Ausgang 2b und einen Steuereingang 2c auf. Der Ausgang 2b der Verstärkungseinheit 2 ist zum einen mit dem Eingang 3a einer ersten Detektorschaltung 3 und mit dem Eingang 4a einer zweiten Detektorschaltung 4 verbunden. Der Ausgang 3b der ersten Detektorschaltung 3 ist mit dem Steuereingang 2c der Verstärkungseinheit 2 verschaltet. Der Ausgang 4b der zweiten Detektorschaltung 4 führt zu einer Ausgangsklemme 5.

Die Verstärkungseinheit 2 ist in ihrer Verstärkung steuerbar und kann z.B. mehrere Verstärkungsstufen, Steuereinheiten und Zusatzschaltungen wie z.B. Filter enthalten. Die Detektoren 3, 4 dienen dazu, das Signal am Ausgang der Verstärkungseinheit 2 zu detektieren, d.h. ein Ausgangssignal zu erzeugen, sobald ein Eingangssignal eine bestimmte vorgegebene Schwelle überschreitet. Die Schwellen der beiden Detektorschaltungen 3 und 4 sind erfindungsgemäß unterschiedlich ausgelegt. Zum einwandfreien Funktionieren der Schaltung muß die Schwelle der Detektorschaltung 3 niedriger als die Schwelle der Detektorschaltung 4 liegen.

Liegt nun ein verrauschtes Eingangssignal an der Eingangsklemme 1 an, so wird dieses von der Verstärkungseinheit 2 verstärkt. Der Verstärkungsfaktor der Verstärkungseinheit 2 wird nun durch die Detektorschaltung 3 geregelt. Dies geschieht solange, bis das Rauschen am Ausgang der Verstärkungseinheit 2 niedriger als die Schwelle der Detektorschaltung 3 ist. Aufgrund der Trägheit des Regelkreises werden aber Signalspitzen, die das Nutzsignal darstellen und aus dem Rauschen deutlich herausragen, von der zweiten Detektorschaltung 4 erkannt und ein entsprechendes Ausgangssignal ist an der Ausgangsklemme 5 abgreifbar.

Figur 2 zeigt Einzelheiten der Detektorschaltung. Der Detektor ist symmetrisch aufgebaut und weist zwei Eingangsklemmen 10, 13 auf. Die Eingangsklemmen sind jeweils mit der Basis eines ersten und zweiten Transistors 11, 12 verbunden. Die Kollektoren der beiden Transistoren 11 und 12 sind mit der Versorgungsspannung über die Klemme 6 verschaltet. Die Emitter der beiden Transistoren 11, 12 sind über jeweils einen ersten und zweiten Widerstand 14, 19 mit einer Stromschaltung verbunden. Der Stromspiegel besteht aus einer Stromquelle 7, einem dritten, vierten und fünften Transistor 20, 21, 26. Die Stromquelle 7 ist zum einen mit der Versorgungsspannung über die Klemme 6 und zum anderen mit dem Kollektor des dritten Transistors 20 verschaltet. Die Emitter des dritten, vierten und fünften Transistors 20, 21, 26 sind mit Masse verbunden. Weiterhin sind die Basisanschlüsse des dritten, vierten und fünften Transistors 20, 21, 26 miteinander und mit dem Kollektor des dritten Transistors 20 verbunden. Das am Emitter des ersten Transistors 11 anliegende Signal und das am Kollektor des fünften Transistors 26 anliegende Signal wird einer Differenzverstärkerstufe zugeführt. Diese Differenzverstärkerstufe besteht aus einem sechsten, siebten, achten und neunten Transistor 17, 18, 24, 25. Der Emitter des ersten Transistors 11 ist dabei mit der Basis des sechsten Transistors 17 und der Kollektor des fünften Transistors 26 mit der Basis des siebten Transistors 18 verbunden. Die Emitteranschlüsse des siebten und achten Transistors 17, 18 werden von einer Stromquelle 9 gespeist, die wiederum mit der Versorgungsspannung über die Klemme 6 verbunden ist. Der Kollektor des sechsten Transistors 17 ist über die Laststrecke des achten Transistors mit Masse 32 verbunden. Ebenso ist der Kollektor des siebten Transistors 18 über die Laststrecke des neunten Transistors 25 mit Masse verschaltet. Die Basisanschlüsse des achten und neunten Transistors sind zum einen miteinander verbunden und zum anderen mit dem Kollektor des neunten Transistors 25 verschaltet.

Eine zweite Differenzverstärkerstufe bestehend aus einem zehnten, elften, zwölften und dreizehnten Transistors 15, 16, 22, 23 ist vorgesehen. Der Emitter des zweiten Transistors 12 ist mit der Basis des elften Transistors 16 und der Kollektor des vierten Transistors 21 mit der Basis des zehnten Transistors 15 verbunden. Die Emitter des zehnten und elften Transistors 15, 16 werden wiederum von einer dritten Stromquelle 8 gespeist, die ihrerseits mit der Versorgungsspannung über die Klemme 6 verschaltet ist. Die Kollektoren des zehnten und elften Transistors 15, 16 sind jeweils über die Laststrekken des zwölften und dreizehnten Transistors 22, 23 mit Masse verbunden. Die Basisanschlüsse des zwölften und dreizehnten Transistors 22, 23 sind wiederum miteinander und mit dem Kollektor des zwölften Transistors 22 verbunden.

An den Kollektoren des sechsten und elften Transistors 17, 16 befinden sich die Ausgänge 34, 35 der Differenzverstärker. Der Kollektor des elften Transistors 16 ist mit der Basis eines vierzehnten Transistors 28 verschaltet. Ebenso ist der Kollektor des sechsten Transistors 17 mit der Basis eines fünfzehnten Transistors 29 verbunden. Die Kollektoren des vierzehnten und fünfzehnten Transistors werden von einer vierten Stromquelle 33 gespeist. Eine Ausgangsklemme 31 ist ebenfalls mit den Kollektoren des vierzehnten und fünfzehnten Transistors 28, 29 verschaltet. Beide Emitter des vierzehnten und fünfzehnten Transistors 28, 29 sind mit Masse 32 verbunden. Die Basisanschlüsse des vierzehnten und fünfzehnten Transistors 28, 29 sind zusätzlich über zwei als Dioden geschaltete weitere Transistoren 25, 28 mit Masse verbunden.

Das Eingangssignal an den Klemmen 10 und 13 wird über die Eingangsstufen bestehend aus den Transistoren 11, 12 und der zugehörigen Stromquelle 7 mit nachgeschaltetem Stromspiegel gebildet durch die Transistoren 20, 21 und 26 ausgekoppelt. Durch die beiden Widerstände 14 und 19 kann die Schwelle des Detektors eingestellt werden. Die Ausgangsspannungen an den Widerständen 14 und 19 werden bei Überschreiten der Schwelle durch die Differenzverstärkerstufen 15, 16, 22, 23 und 9, 17, 18, 24, 25 verstärkt und den Endstufentransistoren 28 und 29 zugeführt. Dabei dient je eine Differenzverstärkerstufe zur Detektion und Verstärkung der positiven bzw. negativen Signalhälfte. Als Ausgangssignal wird für jede positive bzw. negative Signalhälfte ein positives Signal erzeugt. Es findet also eine Gleichrichtung statt. Die beiden Dioden 27 und 30 dienen zur Spannungsbegrenzung. Das Ausgangssignal kann an der Klemme 31, die mit dem Kollektor der beiden Ausgangstransistoren 28 und 29 verbunden ist, abgegriffen werden.

Die in dem Ausführungsbeispiel gemäß Figur 2 gezeigte Detektorschaltung stellt eine bevorzugte Ausführungsform für die Detektoren 3, 4 wie sie in Figur 1 dargestellt sind, dar. Der Vorteil der gezeigten Ausführungsform liegt in einem sehr geringen schaltungstechnischen Aufwand. Die Schwelle der Detektoren läßt sich einfach über die Widerstandswerte der beiden Widerstände 14, 19 einstellen. Die gezeigte Ausführungsform ist außerdem auf einfache Weise integrierbar.

Je nach Dimensionierung der Detektorschaltungen kann die Rückregelung auf einen bestimmten Code mit bestimmtem Taktverhältnis optimiert werden. Dadurch bewirkt das Signal keine weiteren wesentlichen Rückregelungen des Verstärkungsfaktors durch die erste Detektorschaltung 3.

Die Erfindung ist in Bipolartechnik beschrieben, kann aber selbstverständlich auch in MOS-Technik ausgeführt werden.

## Patentansprüche

1. Integrierbare Schaltungsanordnung zum Detektieren eines digitalen Nutzsignales in einem verrauschten Eingangssignal, **gekennzeichnet durch**
- eine regelbare Verstärkungseinheit (2) mit einem Eingang (2a), einem Ausgang (2b) und einem Steuereingang (2c), wobei dem Eingang (2a) das Eingangssignal zugeführt wird,
- zwei Detektoreinheiten (3, 4) mit je einem Eingang (3a; 4a) und einem Ausgang (3b; 4b), wobei von jeder Detektoreinheit (3, 4) jeweils dann ein Ausgangssignal erzeugt wird, wenn die Amplitude eines ihr zugeführten Eingangssignals eine im jeweiligen Detektor (3, 4) gebildete Detektorschwelle überschreitet, wobei die Detektorschwelle des ersten Detektors (3) unterhalb der Schwelle des zweiten Detektors (4) liegt und wobei die Eingänge (3a;4a) der beiden Detektoren (3, 4) mit dem Ausgang (2b) der Verstärkungseinheit (2) und der Ausgang (3b) des ersten Detektors (3) mit dem Steuereingang (2c) der Verstärkungseinheit (2) verbunden ist, so daß die Verstärkungseinheit (2) über den ersten Detektor (3) gegengekoppelt ist,
- eine Ausgangsklemme (5), die mit dem Ausgang (4b) des zweiten Detektors (4) verbunden ist und an der das Ausgangssignal der Schaltungsanordnung abgreifbar ist.

2. Integrierbare Schaltungsanordnung nach Anspruch 1,
**dadurch gekennzeichnet,**
daß die Detektoren (3, 4) jeweils zwei Differenzverstärker mit einstellbarer Schwelle zur Bildung der Detektorschwelle aufweisen, und daß die beiden Differenzverstärker vom Eingangssignal gegenphasig angesteuert werden.

3. Integrierbare Schaltungsanordnung nach Anspruch 2,
**dadurch gekennzeichnet**,
daß zum Auskoppeln der Eingangssignale im Detektor (3, 4) jeweils ein Eingangstransistor (11, 12) vorgesehen ist, dessen Basis das Eingangssignal des Detektors zugeführt wird, dessen Kollektor mit einer Klemme (6) der Versorgungsspannungsquelle und dessen Emitter über einen Widerstand (14; 19) mit einem Anschluß einer Stromquelle (7, 20, 21, 26) verbunden ist, und daß an den beiden Anschlüssen der Widerstände (14; 19) jeweils ein Eingangssignal für einen der Differenzverstärker abgreifbar ist.

4. Integrierbare Schaltungsanordnung nach Anspruch 2 oder 3,
**dadurch gekennzeichnet,**
daß die Ausgänge (34, 35) der Differenzverstärker jeweils mit dem Basisanschluß je eines Ausgangstransistors (28, 29) verbunden sind, deren Emitter mit einem Masseanschluß (32), deren Kollektoren mit einer Stromquelle (33) und mit der Ausgangsklemme (31) des Detektors (3; 4) verbunden sind.

5. Integrierbare Schaltungsanordnung nach Anspruch 4,
**dadurch gekennzeichnet,**
daß der Basisanschluß eines jeden Ausgangstransistors (28; 29) über je eine Diode (27; 30) mit Masse (32) verbunden ist.

## Claims

1. Integrated circuit arrangement for detecting a digital useful signal within a noisy input signal, characterized by
- a controllable amplifying unit (2) having an input (2a), an output (2b) and a control input (2c), the input signal being fed to the input (2a),
- two detector units (3, 4) each having an input (3a; 4a) and an output (3b; 4b), an output signal being generated by each detector unit (3, 4) in each case when the amplitude of an input signal fed to it exceeds a detector threshold formed in the respective detector (3, 4), the detector threshold of the first detector (3) being below the threshold of the second detector (4), and the inputs (3a; 4a) of the two detectors (3, 4) being connected to the output (2b) of the amplifying unit (2), and the output (3b) of the first detector (3) being connected to the control input (2c) of the amplifying unit (2), with the result that the amplifying unit (2) receives negative feedback via the first detector (3),
- an output terminal (5), which is connected to the output (4b) of the second detector (4) and at which the output signal of the circuit arrangement can be tapped.

2. Integrated circuit arrangement according to Claim 1, characterized in that the detectors (3, 4) in each case have two differential amplifiers with an adjustable threchold for forming the detector threshold, and in that the two differential amplifiers are driven in phase opposition by the input signal.

3. Integrated circuit arrangement according to Claim 2, characterized in that for the purpose of coupling out the input signals there is provided in the detector (3, 4) in each case an input transistor (11, 12) whose base is fed the input signal of the detector, whose collector is connected to a terminal (6) of the supply voltage source, and whose emitter is connected via a resistor (14; 19) to a terminal of a current source (7, 20, 21, 26), and in that an input signal for one of the differential amplifiers can respectively be tapped at the two terminals of the resistors (14; 19).

4. Integrated circuit arrangement according to Claim 2 or 3, characterized in that the outputs (34, 35) of the differential amplifiers are respectively connected to the base terminal of in each case one output transistor (28, 29) whose emitters are connected to a frame terminal (32), and whose collectors are connected to a current source (33) and to the output terminal (31) of the detector (3; 4).

5. Integrated circuit arrangement according to Claim 4, characterized in that the base terminal of each output transistor (28; 29) is connected to frame (32) via a diode (27; 30) in each case.

## Revendications

1. Montage pouvant être intégré et destiné à la détection d'un signal numérique utile dans un signal d'entrée affecté de bruit, caractérisé par
- une unité (2) d'amplification réglable comportant une entrée (2a), une sortie (2b) et une entrée (2c) de commande, le signal d'entrée étant envoyé à l'entrée (2a),
- deux unités (3,4) de détecteur comprenant chacune une entrée (3a;4a) et une sortie (3b;4b), un signal de sortie étant produit par chaque unité (3,4) de détecteur, lorsque l'amplitude d'un signal d'entrée qui lui est envoyé devient supérieure à un seuil de détection formé dans le détecteur considéré (3,4), le seuil de détection du premier détecteur (3) étant inférieur au seuil du second détecteur (4) et les entrées (3a;4a) des deux détecteurs (3,4) étant reliées à la sortie (2b) de l'unité (2) d'amplification et la sortie (3b) du premier détecteur (3) étant reliée à rentrée (2c) de commande de l'unité (2) d'amplification, de sorte que runité (2) d'amplification soit en contre-réaction par l'intermédiaire du premier détecteur (3),
- une borne (5) de sortie, qui est reliée à la sortie (4b) du second détecteur (4) et de laquelle peut être prélevé le signal de sortie du montage.

2. Montage pouvant être intégré suivant la revendication 1,
caractérisé en ce que
les détecteurs (3,4) comportent chacun deux amplificateurs différentiels à seuil réglable pour la formation du seuil de détection et les deux amplificateurs différentiels sont commandés en opposition de phase par le signal d'entrée.

3. Montage pouvant être intégré suivant la revendication 2,
caractérisé en ce que
Il est prévu pour découpler les signaux d'entrée dans le détecteur (3,4) un transistor (11,12) d'entrée, à la base duquel est envoyé le signal d'entrée du détecteur, dont le collecteur est relié à une bome (6) de la source de tension d'alimentation et dont l'émetteur est relié par l'intermédiaire d'une résistance (14;19) à une borne d'une source (7,20,21,26) de courant, et un signal d'entrée pour l'un des amplificateurs différentiels peut être prélevé des deux bornes des résistances (14;19).

4. Montage pouvant être intégré suivant la revendication 2 ou 3,
caractérisé en ce que
les sorties (34,35) des amplificateurs différentiels sont reliées respectivement à la borne de base de transistors (28,29) de sortie, dont les émetteurs sont reliés à une borne (32) de masse, dont les collecteurs sont reliés à une source (33) de courant et à la borne (31) de sortie du détecteur (3;4).

5. Montage pouvant être intégré suivant la revendication 4,
caractérisé en ce que
la borne de base de chaque transistor (28;29) de sortie est reliée à la masse (32) par l'intermédiaire d'une diode (27;30).
